(19) Europäisches Patentamt
European Patent Office
Office européen des brevets

(11) **EP 4 339 558 B1**

(12) **EUROPEAN PATENT SPECIFICATION**

(45) Date of publication and mention
of the grant of the patent:
**29.10.2025 Bulletin 2025/44**

(51) International Patent Classification (IPC):
***G01C 21/16*** (2006.01)     ***G01C 25/00*** (2006.01)
***G01S 19/49*** (2010.01)

(21) Application number: **23195811.7**

(22) Date of filing: **06.09.2023**

(52) Cooperative Patent Classification (CPC):
**G01C 21/16; G01C 25/005;** G01S 19/49

(54) **AUTONOMOUS NAVIGATION SYSTEM**

AUTONOMES NAVIGATIONSSYSTEM

SYSTÈME DE NAVIGATION AUTONOME

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **14.09.2022 JP 2022146423**

(43) Date of publication of application:
**20.03.2024 Bulletin 2024/12**

(73) Proprietor: **Alps Alpine Co., Ltd.
Ota-ku,
Tokyo 145-8501 (JP)**

(72) Inventor: **Seino, Hiroyuki
Iwaki-city, Fukushima (JP)**

(74) Representative: **Schmitt-Nilson Schraud Waibel
Wohlfrom
Patentanwälte Partnerschaft mbB
Pelkovenstraße 143
80992 München (DE)**

(56) References cited:
**US-A1- 2010 030 471**    **US-A1- 2010 292 915**
**US-A1- 2013 338 915**    **US-A1- 2018 245 924**

**Description**

The present invention relates to an autonomous navigation system using a Kalman filter.

As an autonomous navigation system using a Kalman filter, an autonomous navigation system mounted on an automobile is known (for example, JP 5164645).

In this autonomous navigation system, an output of a vehicle speed sensor, an output of an acceleration sensor that detects accelerations in three axis directions, an output of a gyroscope that detects angular velocities around three axes, and an output of a GPS receiver are processed through a repeated extended Kalman filter to estimate a state of a three-dimensional position vector or the like of an automobile.

In addition, as a technique related to the present invention, a technique for detecting an attachment angle of a device including an acceleration sensor and a gyroscope with respect to an automobile using an output of the acceleration sensor that detects an acceleration in an Xs-axis direction, an output of the gyroscope that detects angular velocity around a Zs-axis perpendicular to the Xs-axis, and an output of a GPS receiver is known (for example, JP 2004 -239613 A).

Here, in this technique, assuming that an axis directed in the forward direction of the automobile is Xm and an axis directed in the upward direction of the automobile is Zm, a pitch angle $\theta$pitch, a yaw angle $\theta$yow, and a roll angle $\theta$roll of an Xs-Zs coordinate system with respect to an Xm-Zm coordinate system are obtained as attachment angles with respect to the automobile as follows.

That is, an acceleration As output from the acceleration sensor when an acceleration component in a traveling direction of a vehicle is zero is integrated, and the averaged value Aave is calculated. Then, as represented by Formula 1, the value Aave is divided by the gravitational acceleration g to obtain sin($\theta$pitch), and the pitch angle $\theta$pitch is obtained from the value of sin($\theta$pitch).

[Math. 1]

$$\sin(\theta\,\mathrm{pitch}) = \frac{A\,\mathrm{ave}}{g} \quad \text{... Formula 1}$$

Next, as represented by Formula 2, g×sin($\theta$pitch) is subtracted from the acceleration As to obtain a value Asx. Then, an acceleration Ar in the X-axis direction of the automobile is obtained on the basis of the output of the GPS receiver, cos($\theta$yaw) is obtained by dividing the value Asx by the cosine value Ar×cos($\theta$pitch) of the acceleration Ar as represented by Formula 3, and the yaw angle $\theta$yaw is obtained from the value of cos($\theta$yaw).

[Math. 2]

$$A\mathrm{sx} = A\mathrm{s} - g \times \sin(\theta\,\mathrm{pitch}) \quad \text{... Formula 2}$$

$$\cos(\theta\,\mathrm{yaw}) = \frac{A\mathrm{sx}}{A\mathrm{r} \times \cos(\theta\,\mathrm{pitch})} \quad \text{... Formula 3}$$

In addition, the angular velocity $\omega$r around the Z axis of the automobile is obtained on the basis of the output of the GPS receiver, and the sensitivity Sg of the gyroscope is obtained by obtaining the ratio of the angular velocity or to the angular velocity $\omega$s output from the gyroscope as represented by Formula 4. Then, as represented by Formula 5, cos($\theta$roll) is obtained by dividing the sensitivity Sg by cos($\theta$pitch), and the roll angle $\theta$roll is obtained from the value of cos($\theta$roll).

[Math. 3]

$$S\mathrm{g} = \frac{\omega\,\mathrm{s}}{\omega\,\mathrm{r}} \quad \text{... Formula 4}$$

$$\cos(\theta\,\mathrm{roll}) = \frac{S\mathrm{g}}{\cos(\theta\,\mathrm{pitch})} \quad \text{... Formula 5}$$

In a case in which an autonomous navigation system is constructed using a six-axis inertial sensor including an acceleration sensor that detects accelerations in three axis directions and a gyroscope that detects angular velocities around three axes, and a Kalman filter, it is also necessary to estimate an attachment angle of the six-axis inertial sensor to the automobile as a state with respect to calculation of a three-dimensional position vector of an automobile.

However, when the attachment angle of the six-axis inertial sensor with respect to the automobile deviates from a standard value of the attachment angle set as an initial value, it takes a long time until the estimated value of the attachment angle converges, or the estimated value of the attachment angle converges to an incorrect value.

In addition, when the yaw angle of the attachment angle of the six-axis inertial sensor with respect to the automobile exceeds $\pm90°$, the attachment angle exceeds an allowable range of the estimation capability of the Kalman filter, and thus the estimated value of the attachment angle may diverge without converging.

This hinders proper calculation of a state of an automobile such as a three-dimensional position vector in an autonomous navigation system using an inertial sensor and a Kalman filter.

US 2013/338915 A1 discloses a method, e.g. in a car navigation apparatus, for determining an attitude of a sensor with respect to a moving body, wherein a movement vector is measured by a sensor mounted in the moving body. In addition, the attitude of the sensor with respect to the moving body is determined using the movement vector measured by the sensor when the moving body starts to move. Inertial navigation operation results are coordinate-transformed to a moving body coordinate position, a moving body coordinate velocity vector, and a moving body attitude angle expressed in the moving body coordinate system, respectively. A KF error estimation section estimates an inertial navigation operation error included in the inertial navigation operation result in the NED coordinate system using a Kalman filter.

US 2010/030471 A1 discloses a position detecting apparatus and method used in a navigation system, which can improve positional accuracy and bearing accuracy even in a system equipped with few sensors.

Therefore, an object of the present invention is to appropriately calculate a state of a moving body regardless of an attachment angle of an inertial sensor with respect to the moving body in an autonomous navigation system using the inertial sensor and a Kalman filter mounted on the moving body.

The invention relates to an autonomous navigation system according to the appended claims. Embodiments are disclosed in the dependent claims.

According to an aspect of the present invention, an autonomous navigation system mounted on a moving body includes: an inertial sensor; a yaw angle angle range detection means configured to detect, as a yaw angle angle range, an angle range to which a yaw angle of an attachment angle of the inertial sensor with respect to the moving body belongs; a conversion means configured to convert and output an output of the inertial sensor; and a Kalman filter configured to estimate a state of the moving body using an output of the conversion means. Here, the state estimated by the Kalman filter includes an attachment angle of the inertial sensor, and the conversion means converts the output of the inertial sensor into an output of a virtual inertial sensor in which a yaw angle of an attachment angle with respect to the moving body is at least within $\pm90°$ according to the yaw angle angle range detected by the yaw angle angle range detection means, and outputs the converted output.

In an autonomous navigation system according to an embodiment, the yaw angle angle range detection means detects, as the yaw angle angle range, an angle range to which the yaw angle of the attachment angle of the inertial sensor with respect to the moving body belongs, among an angle range between -45° and +45°, an angle range between +45° and +135°, an angle range between +135° and +180°, an angle range between -45° and -135°, and an angle range between -135° and -180°, and the conversion means may be configured to convert the output of the inertial sensor into an output of a virtual inertial sensor in which a yaw angle of an attachment angle with respect to the moving body is at least within $\pm45°$ according to the yaw angle angle range detected by the yaw angle angle range detection means and to output the converted output.

Furthermore, preferably in a case of such a configuration, the inertial sensor may be an inertial sensor that outputs accelerations (ax, ay, az) in three orthogonal axial directions of X, Y, and Z, and the conversion means preferably performs conversion of the accelerations (ax, ay, az) into accelerations (ax', ay', az') as the conversion, and performs conversion into the accelerations (ax', ay', az') by setting (ax', ay', az') = (ax, ay, az) when the yaw angle angle range detected by the yaw angle angle range detection means is an angle range between -45° and +45°, (ax', ay', az') = (-ay, ax, az) when the yaw angle angle range detected by the yaw angle angle range detection means is an angle range between +45° and +135°, (ax', ay', az') = (-ax, -ay, az) when the yaw angle angle range detected by the yaw angle angle range detection means is an angle range between +135° and +180°, (ax', ay', az') = (ay, -ax, az) when the yaw angle angle range detected by the yaw angle angle range detection means is an angle range between -45° and -135°, and (ax', ay', az') = (-ax, -ay, az) when the yaw angle angle range detected by the yaw angle angle range detection means is an angle range between -135° and -180°.

Furthermore, preferably in a case of such a configuration, the inertial sensor may be an inertial sensor that outputs angular velocities ($\omega$x, $\omega$y, $\omega$z) around three orthogonal axes of X, Y, and Z, and the conversion means may perform conversion of the angular velocities ($\omega$x, $\omega$y, $\omega$z) into angular velocities ($\omega$x', $\omega$y', $\omega$z') as the conversion, and perform conversion into the angular velocities ($\omega$x', $\omega$y', $\omega$z') by setting ($\omega$x', $\omega$y', $\omega$z') = ($\omega$x, $\omega$y, $\omega$z) when the yaw angle angle range detected by the yaw angle angle range detection means is an angle range between -45° and +45°, ($\omega$x', $\omega$y', $\omega$z') = (-$\omega$y, $\omega$x, $\omega$z) when the yaw angle angle range detected by the yaw angle angle range detection means is an angle range between +45° and +135°, ($\omega$x', $\omega$y', $\omega$z') = (-$\omega$x, -$\omega$y, $\omega$z) when the yaw angle angle range detected by the yaw angle angle range detection means is an angle range between +135° and +180°, ($\omega$x', $\omega$y', $\omega$z') = ($\omega$y, - $\omega$x, $\omega$z) when the yaw angle angle range detected by the yaw angle angle range detection means is an angle range between -45° and -135 °, and $(\omega x', \omega y', \omega z')$ = $(-\omega x, -\omega y, \omega z)$ when the yaw angle angle range detected by the yaw angle angle range detection means is an angle range between -135° and -180°.

Furthermore, preferably in a case of such a configuration, the inertial sensor may be an inertial sensor that outputs accelerations (ax, ay, az) and angular velocities $(\omega x, \omega y, \omega z)$, and the conversion means may perform, as the conversion, conversion of the accelerations (ax, ay, az) into accelerations (ax', ay', az') and conversion of the angular velocities $(\omega x, \omega y, \omega z)$ into angular velocities $(\omega x', \omega y', \omega z')$.

As described above, in the Kalman filter, the output of the inertial sensor is converted by the conversion means to generate the output of the virtual inertial sensor in which the yaw angle of the attachment angle is within ±90° or ±45°, and the output is input to the Kalman filter instead of the output of the inertial sensor, whereby divergence of estimation of the attachment angle can be curbed in the Kalman filter regardless of the attachment angle of the inertial sensor with respect to the moving body, and it can be expected that estimation of the attachment angle can rapidly converge to a correct value.

Here, in the autonomous navigation system including the above-described yaw angle angle range detection means, the yaw angle angle range detection means may be configured to detect the yaw angle of the attachment angle of the inertial sensor with respect to the moving body, and the autonomous navigation system may include an initial value setting means configured to calculate a yaw angle of the virtual inertial sensor on the basis of the yaw angle and the yaw angle range detected by the yaw angle angle range detection means and to set the yaw angle in the Kalman filter as an initial value of a yaw angle of an attachment angle estimated by the Kalman filter.

Furthermore, in this case, the yaw angle angle range detection means may further detect a roll angle and a pitch angle of the attachment angle of the inertial sensor with respect to the moving body, and the initial value setting means may calculate a pitch angle of the virtual inertial sensor on the basis of the roll angle, the pitch angle, and the yaw angle angle range detected by the yaw angle angle range detection means, and set the pitch angle in the Kalman filter as an initial value of a pitch angle of an attachment angle estimated by the Kalman filter.

Furthermore, in the autonomous navigation system that detects a yaw angle angle range from among an angle range between -45° and +45 °, an angle range between +45° and +135°, an angle range between +135° and +180°, an angle range between -45° and -135°, and an angle range between -135° and -180° through a yaw angle angle range detection means, the yaw angle angle range detection means may be configured to detect a roll angle A1, a pitch angle A2, and a yaw angle A3 of the attachment angle of the inertial sensor with respect to the moving body, and the autonomous navigation system may include an initial value setting means that sets an initial value SA2 of the pitch angle and an initial value SA3 of the yaw angle of the attachment angle estimated by the Kalman filter. In this case, the initial value setting means calculates the initial value SA2 and the initial value SA3 of the yaw angle as SA2 = A2 and SA3 = A3 when the yaw angle angle range detected by the yaw angle angle range detection means is an angle range between -45° and +45°, SA2 = A1 and SA3 = A3-90° when the yaw angle angle range detected by the yaw angle angle range detection means is an angle range between +45° and +135°, SA2 = -A2 and SA3 = A3-180° when the yaw angle angle range detected by the yaw angle angle range detection means is an angle range between +135° and +180°, SA2 = -A1 and SA3 = A3+90° when the yaw angle angle range detected by the yaw angle angle range detection means is an angle range between -45° and -135°, and SA2 = -A2 and SA3 = A3+180° when the yaw angle angle range detected by the yaw angle angle range detection means is an angle range between -135° and -180°.

As described above, by setting the initial value of the attachment angle estimated by the Kalman filter, it can be expected that estimation of the attachment angle of the six-axis inertial sensor rapidly converges without diverging.

As described above, according to aspects of the present invention, in an autonomous navigation system using an inertial sensor and a Kalman filter mounted on a moving body, a state of the moving body can be appropriately calculated regardless of an attachment angle of the inertial sensor with respect to the moving body.

Fig. 1 is a block diagram illustrating a configuration of an autonomous navigation system according to an embodiment of the present invention.

Figs. 2A and 2B are diagrams illustrating yaw angles of an attachment angle of a six-axis inertial sensor with respect to an automobile, estimated by a Kalman filter in an embodiment of the present invention.

Figs. 3A to 3E are diagrams illustrating examples of transformation from a coordinate system of a six-axis inertial sensor to a coordinate system of a virtual six-axis inertial sensor in an embodiment of the present invention.

Hereinafter, embodiments of the present invention will be described.

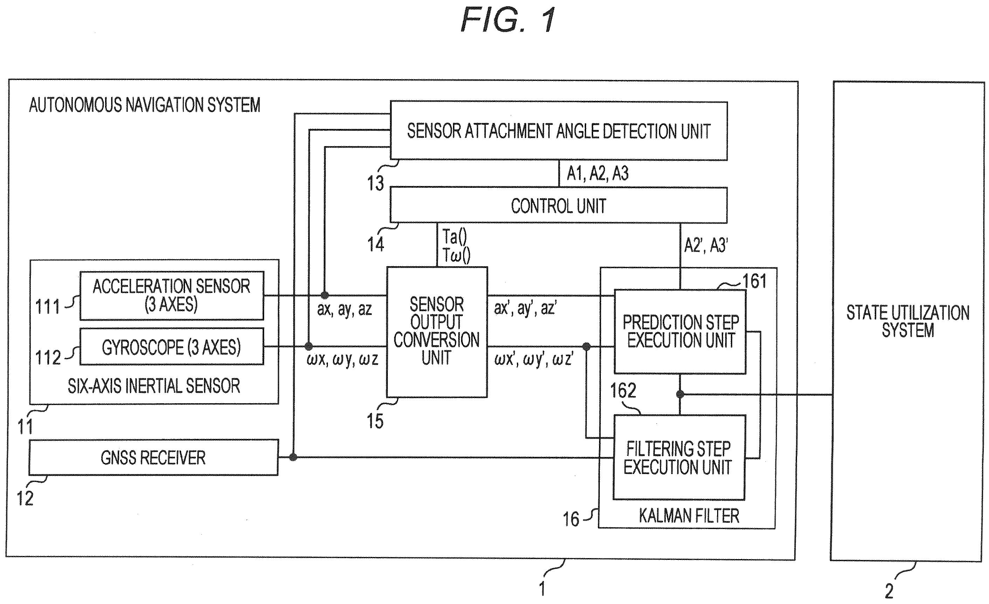

Fig. 1 illustrates a configuration of an autonomous navigation system according to an embodiment.

The autonomous navigation system 1 is a system that is mounted on an automobile and calculates a state of the automobile such as a position vector of the automobile, and the state of the automobile such as the position vector of the automobile calculated by the autonomous navigation system 1 is used by a state utilization system 2 that is an autonomous driving system, a navigation system, or the like also mounted on the automobile.

As illustrated, the autonomous navigation system 1 includes a six-axis inertial sensor 11, a GNSS receiver 12 that performs satellite positioning, a sensor attachment angle detection unit 13, a control unit 14, a sensor output conversion unit 15, and a Kalman filter 16.

Further, the six-axis inertial sensor 11 includes an acceleration sensor 111 that detects accelerations ax, ay, and az in three-axis directions of Xs, Ys, and Zs in a sensor coordinate system that is an orthogonal coordinate system fixed with respect to the six-axis inertial sensor 11, and a gyroscope 112 that detects angular velocities ωx, ωy, and ωz around three axes Xs, Ys, and Zs.

Further, the Kalman filter 16 includes a prediction step execution unit 161 and a filtering step execution unit 162.

The sensor output conversion unit 15 converts the accelerations ax, ay, and az output from the acceleration sensor 111 into accelerations ax', ay', and az' according to an acceleration conversion function Ta set by the control unit 14, outputs the converted accelerations to the Kalman filter 16, converts the angular velocities ωx, ωy, and ωz output from the gyroscope 112 into angular velocities ωx', ωy', and ωz' according to an angular velocity conversion function Tω set by the control unit 14, and outputs the converted angular velocities to the Kalman filter 16.

Next, the Kalman filter 16 estimates a state $X_k$ of the automobile at each point in time k according to a state equation represented by Formula 6 and an observation equation represented by Formula 7.

[Math. 4]

$$\mathbf{X_k} = \mathbf{f(X_{k-1}, u_k)} + \mathbf{q_k} \quad \ldots \text{Formula 6}$$

$$\mathbf{z_k} = \mathbf{h(x_k)} + \mathbf{r_k} \quad \ldots \text{Formula 7}$$

The estimated state $X_k$ of the automobile includes a three-dimensional position vector (three-dimensional movement distance) of the automobile, a three-dimensional velocity vector of the six-axis inertial sensor 11, attitude angles of roll, pitch, and yaw of the six-axis inertial sensor 11, a pitch angle and a yaw angle of an attachment angle of the six-axis inertial sensor 11 with respect to the automobile, sensitivities and biases of the acceleration sensor 111 and the gyroscope 112, and the like.

In Formula 6, $u_k$ represents an input vector including accelerations ax', ay', and az' and angular velocities ωx', ωy', and ωz' input from the sensor output conversion unit 15, and $q_k$ represents an error of the input vector. Further, f is a nonlinear function for deriving the state $X_k$ from a state $X_{k-1}$ at the previous point in time k -1 and the input vector $u_k$ in a case in which there is no error $q_k$.

In Formula 7, $Z_k$ represents a measured value of the GNSS receiver input to the Kalman filter 16 via a signal processing unit or a measured value including angular velocities ωx', ωy', and ωz' or the like input from the sensor output conversion unit 15, and $r_k$ represents an error of the measured value. Further, h is a nonlinear function for deriving the measured value $Z_k$ from the state $X_k$ in a case in which there is no error $r_k$.

The prediction step execution unit 161 and the filtering step execution unit 162 of the Kalman filter 16 perform, for example, the following processing.

That is, the prediction step execution unit 161 of the Kalman filter 16 calculates a prior estimated value $X^-_{k+1}$ of a state $X_{k+1}$ according to Formula 8 at the point in time k. Here, $X^+_k$ in Formula 8 is a posterior estimated value calculated by the filtering step execution unit 162 at the previous point in time k.

[Math. 5]

$$x^-_{k+1} = \begin{cases} f(x^-_k, u_k) & \text{(When a measured value is not obtained in a previous point in time k and a posterior estimated value is not calculated)} \\ f(x^+_k, u_k) & \text{(When a measured value is obtained in a previous point in time k and a posterior estimated value is calculated)} \end{cases} \quad \ldots \text{Formula 8}$$

In addition, the prediction step execution unit 161 calculates a prior error covariance $P^-_{k+1}$ according to Formula 9. In Formula 9, $\Phi_k$ and $\Gamma_k$ are matrices defined by Jacobian of the nonlinear function f, $\Phi^T_k$ and $\Gamma^T_k$ are transposed matrices of $\Phi_k$ and $\Gamma_k$, $P^+_k$ is a posterior error covariance calculated by the filtering step execution unit 162 at the previous point in time k, and $Q_k$ is a covariance matrix representing the error $q_k$.

[Math. 6]

$$P^-_{k+1} = \begin{cases} \Phi_k P^-_k \Phi^T_k + \Gamma_k Q_k \Gamma^T_k & \text{(When a measured value is not obtained in a previous point in time k and a posterior estimated value is not calculated)} \\ \Phi_k P^+_k \Phi^T_k + \Gamma_k Q_k \Gamma^T_k & \text{(When a measured value is obtained in a previous point in time k and a posterior estimated value is calculated)} \end{cases} \quad \ldots \text{Formula 9}$$

Next, in a case in which a measured value is obtained at the point in time k, the filtering step execution unit 162 executes a filtering step that is repeated a predetermined number of times such as once or a plurality of times or until a predetermined stop condition is satisfied while advancing i from 0 by 1 in Formulas 10, 11, and 12.

[Math. 7]

$$K_{k,i} = P_k^- H_k^T(x_{k,i}^+)\left(H_k(x_{k,i}^+)P_k^- H_k^T(x_{k,i}^+) + R_k\right)^{-1} \quad \text{... Formula 10}$$

$$x_{k,i+1}^+ = x_k^- + K_{k,i}\left[z_k - h_k(x_{k,i}^+) - H_k(x_{k,i}^+)(x_k^- - x_{k,i}^+)\right] \quad \text{... Formula 11}$$

$$P_{k,i+1}^+ = \left(I - K_{k,i}H_k(\hat{x}_{k,i}^+)\right)P_k^- \quad \text{... Formula 12}$$

Formula 10 is a calculation formula of a Kalman gain $K_{k,i}$, $P_k^-$ in the formula is a prior error covariance calculated in a prediction step at the previous point in time k-1. In addition, $x_{k,0}^+$ is a prior estimated value $x_k^-$ calculated in the prediction step at the previous point in time k-1.

In addition, $H_k$ is a matrix defined by Jacobian of the nonlinear function h, $H_k^T$ is a transposed matrix of $H_k$, and $R_k$ is a covariance matrix representing an error $r_k$.

Next, Formula 11 is a formula for calculating a posterior estimated value $X_{k,i+1}^+$, Formula 12 is a formula for calculating a posterior error covariance $P_{k,i+1}^+$, and I in the formula is an identity matrix.

Then, if iteration of Formulas 10, 11, and 12 is stopped n times, the filtering step execution unit 162 sets a posterior estimated value $X_{k,n}^+$ and a posterior error covariance $P_{k,n}^+$ finally obtained as the posterior estimated value $X_k^+$ and the posterior error covariance $P_k^+$.

Then, the posterior estimated value $X_k^+$ is output to the state utilization system 2 as an estimated value of the state $X_{k+1}$ of the automobile together with the posterior error covariance $P_{k,n}^+$ as necessary.

Note that, in a case in which a measured value cannot be obtained at the point in time k and the filtering step cannot be executed, the prior estimated value $X_k^-$ is output to the state utilization system 2 together with the posterior error covariance $P_{k,n}^-$ as an estimated value of the state $X_k$ of the automobile as necessary.

Such processing of the prediction step execution unit 161 of the Kalman filter 16 is started from a point in time k = 1 after the initial value $X_0^-$ of the prior estimated value $X_k^-$ and the initial value $P_0^-$ of the prior error covariance $P_k^-$ are set.

In addition, processing of the filtering step execution unit 162 is started from the point in time k = 1 at which the prediction step execution unit 161 calculates the first prior estimated value $x_1^-$ and the prior error covariance $P_1^-$.

An initial value SA2 of the pitch angle and an initial value SA3 of the yaw angle of the attachment angle of the six-axis inertial sensor 11 with respect to the automobile included in the initial value $X_0^-$ of the prior estimated value $X_k^-$ are set by the control unit 14. As other initial values, an expected value or the like is set.

Hereinafter, setting of the acceleration conversion function Ta and the angular velocity conversion function Tω to the sensor output conversion unit 15 described above and setting of the initial value SA2 of the pitch angle and the initial value SA3 of the yaw angle of the attachment angle of the six-axis inertial sensor 11 as a part of the initial value $X_0^-$ of the prior estimated value $X_k^-$ to the Kalman filter 16, which are performed by the control unit 14, will be described.

First, setting of the acceleration conversion function Ta and the angular velocity conversion function Tω will be described.

The sensor attachment angle detection unit 13 detects an approximate attachment angle (roll angle A1, pitch angle A2, and yaw angle A3) of the six-axis inertial sensor 11 with respect to the automobile at the time of initial setting of the autonomous navigation system 1.

Here, a vehicle coordinate system, which is an orthogonal coordinate system fixed with respect to the automobile, is defined in advance, and three axes of the vehicle coordinate system are an Xm axis directed in the forward direction of the automobile, a Ym axis directed in the right direction of the automobile, and a Zm axis directed in the upward direction of the automobile.

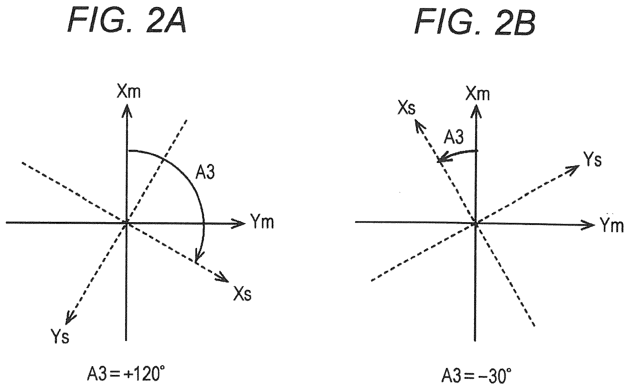

The roll angle A1 of the attachment angle of the six-axis inertial sensor 11 with respect to the automobile is an inclination of the sensor coordinate system around the Xm axis with respect to the vehicle coordinate system, the pitch angle A2 is an inclination of the sensor coordinate system around the Ym axis with respect to the vehicle coordinate system, and the yaw angle A3 is an inclination of the sensor coordinate system around the Zm axis with respect to the vehicle coordinate system as illustrated in Figs. 2A and 2B. In Figs. 2A and 2B, the clockwise direction of the yaw angle A3 is defined as the positive direction.

Such detection of an approximate attachment angle (roll angle A1, pitch angle A2, and yaw angle A3) of the six-axis inertial sensor 11 with respect to the automobile, performed by the sensor attachment angle detection unit 13, can be estimated by Formula 1 to Formula 5 based on the output of the acceleration sensor 111, the output of the gyroscope 112, and the output of the GNSS receiver 12 by applying the technology of Patent Literature 2 described above, for example.

However, detection of the approximate attachment angle (roll angle A1, pitch angle A2, and yaw angle A3) of the six-axis inertial sensor 11 with respect to the automobile, performed by of the sensor attachment angle detection unit 13, may be performed by another method, or a roll angle A1, a pitch angle A2, and a yaw angle A3 set by an operator may be estimated as the roll angle A1, the pitch angle A2, and the yaw angle A3 as they are.

In any case, the estimation accuracy of the roll angle A1, the pitch angle A2, and the yaw angle A3 is set to at least the accuracy with which it can be determined whether each angle belongs to any of -45° to +45°, +45° to +135°, -45° to -135°, and +135° to +180°, and -135° to -180°.

Next, according to the angle range to which the yaw angle A3 detected by the sensor attachment angle detection unit 13 belongs, the control unit 14 sets the acceleration conversion function Ta for converting the accelerations ax, ay, and az output from the acceleration sensor 111 into the accelerations ax', ay', and az' in the sensor output conversion unit 15, and the angular velocity conversion function Tω for converting the angular velocities ωx, ωy, and ωz output from the gyroscope 112 into the angular velocities ωx', ωy', and ωz' in the sensor output conversion unit 15 as follows.

When

$$-45° < A3 < +45°,$$

$$(ax', ay', az') = Ta(ax, ay, az) = (ax, ay, az)$$

$$(ωx', ωy', ωz') = Tω(ωx, ωy, ωz) = (ωx, ωy, ωz)$$

when

$$+45° \leq A3 < +135°,$$

$$(ax', ay', az') = Ta(ax, ay, az) = (-ay, ax, az)$$

$$(ωx', ωy', ωz') = Tω(ωx, ωy, ωz) = (-ωy, ωx, ωz)$$

when

$$+135° \leq A3 < +180°,$$

$$(ax', ay', az') = Ta(ax, ay, az) = (-ax, -ay, az)$$

$$(ωx', ωy', ωz') = Tω(ωx, ωy, ωz) = (-ωx, -ωy, ωz)$$

when

$$-45° \geq A3 > -135°,$$

$$(ax', ay', az') = Ta(ax, ay, az) = (ay, -ax, az)$$

$$(ωx', ωy', ωz') = Tω(ωx, ωy, ωz) = (ωy, -ωx, ωz)$$

when

$$-135° \geq A3 \geq -180°,$$

$$(ax', ay', az') = Ta(ax, ay, az) = (-ax, -ay, az)$$

$$(ωx', ωy', ωz') = Tω(ωx, ωy, ωz) = (-ωx, -ωy, ωz)$$

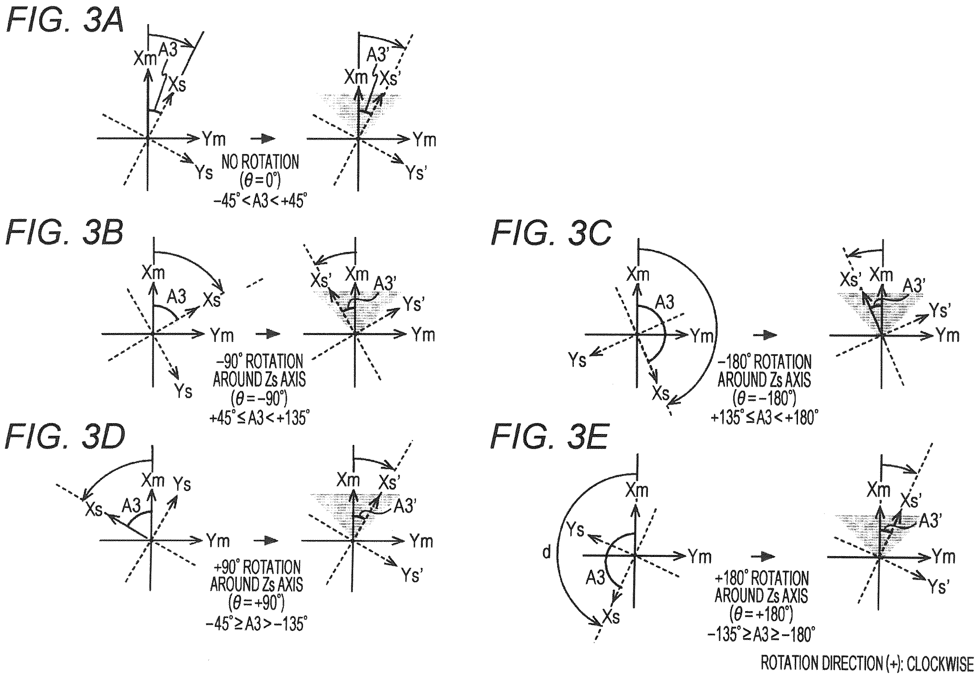

By setting the acceleration conversion function Ta and the angular velocity conversion function Tω in this manner, the accelerations ax, ay, and az output from the acceleration sensor 111 are converted into the acceleration ax' in the Xs' axis direction and ay' representing the acceleration in the Ys' axis direction shown in Figs. 3A to 3E for each angle range to which the yaw angle A3 belongs, and az' representing the acceleration in the Zs axis direction, and the angular velocities ωx, ωy, and ωz output from the gyroscope 112 are converted into ωx' representing the angular velocity around the Xs' axis, ωy' representing the angular velocity around the Ys' axis, and ωz' representing the angular velocity around the Zs axis.

That is, the output of the six-axis inertial sensor 11 is converted into the output of a virtual six-axis inertial sensor having a virtual sensor coordinate system in which the Xs' axis, the Ys' axis, and the Zs axis are orthogonal three axes.

In addition, since the Xs' axis and the ys' axis are obtained by rotating the Xs axis and the ys axis as follows according to the angle range to which the yaw angle A3 belongs in the yaw direction, as illustrated,

0° when -45°<A3<+45°,
-90° when +45°≤A3<+135°,
-180° when +135°≤A3<+180°,
+90° when -45°≥A3>-135°, and
+180° when -135°≥A3≥-180°,
A3' = A3 when -45°<A3<+45°,
A3' = A3-90° when +45°≤A3<+135°,
A3' = A3-180° when +135°≤A3<+180°,
A3' = A3+90° when -45°≥A3>-135°, and
A3' = A3+180° when -135°≥A3≥-180°

a yaw angle A3' of an attachment angle of the virtual six-axis inertial sensor with respect to the automobile is as described above, and thus the yaw angle A3' falls within the range of ±45° indicated in gray in the figure regardless of the yaw angle A3.

Therefore, in the Kalman filter 16, using the output of the virtual six-axis inertial sensor generated according to conversion of the sensor output conversion unit 15 instead of the output of the six-axis inertial sensor 11 is equivalent to using the output of the six-axis inertial sensor in which the yaw angle of the attachment angle with respect to the automobile is A3' 'within the range of ±45°.

Therefore, it can be expected that estimation of the attachment angle is prevented from diverging regardless of the attachment angle of the six-axis inertial sensor 11 with respect to the automobile, and estimation of the attachment angle can rapidly converge to a correct value.

Next, setting of the initial value SA2 of the pitch angle and the initial value SA3 of the yaw angle of the attachment angle of the six-axis inertial sensor 11, performed by the control unit 14, will be described.

Here, the Kalman filter 16 estimates the pitch angle and the yaw angle of the attachment angle with respect to the vehicle coordinate system that is the virtual six-axis inertial sensor coordinate system in which the Xs' axis, the Ys' axis, and the Zs' axis are orthogonal three axes, obtained by rotating the coordinate system of the six-axis inertial sensor 11 in which the Xs axis, the Ys axis, and the Zs axis are orthogonal three axes around the Zs axis by an angle θ determined according to the angle range to which the yaw angle A3 detected by the sensor attachment angle detection unit 13 belongs.

Therefore, the control unit 14 sets the initial value SA2 of the pitch angle and the initial value SA3 of the yaw angle of the attachment angle to the Kalman filter 16 as follows according to the pitch angle A2 and the yaw angle A3 detected by the sensor attachment angle detection unit 13 and the angle range to which the yaw angle A3 belongs.

That is,

$$SA2 = A2, \theta = 0°,$$

and SA3 = A3+θ when -45°<A3<+45°,

$$SA2 = A2, \theta = -180°,$$

and SA3 = A3+θ when +135°≤A3<+180°, and

$$SA2 = A2, \theta = +180°,$$

and SA3 = A3+θ when -135°≥A3≥-180°.

Further, in a case in which the angle range to which the yaw angle A3 detected by the sensor attachment angle detection unit 13 belongs is in the following range and it can be expected that the Zs axis of the sensor coordinate system approximates the Zm axis of the vehicle coordinate system, the initial value SA2 of the pitch angle and the initial value SA3 of the yaw angle of the attachment angle are set as follows according to the roll angle A1 and the yaw angle A3 detected by the sensor attachment angle detection unit 13 and the angle range to which the yaw angle A3 belongs.

$$SA2 = A1, \theta = -90°,$$

and SA3 = A3+0 when +45°≤A3<+135°

$$SA2 = -A1, \theta = +90°,$$

and SA3 = A3+θ when -45°≥A3≥-135°

By setting the initial value SA2 of the pitch angle and the initial value SA3 of the yaw angle of the attachment angle as described above in the control unit 14, it can be expected that estimation of the pitch angle and the yaw angle of the attachment angle of the six-axis inertial sensor 11 rapidly converges without diverging.

Although the yaw angle A3' of the virtual six-axis inertial sensor falls within the range of ±45° in the above embodiment, the range in which the yaw angle A3' falls is not necessarily the range of ±45°, and may be any range of less than ±90°.

Reference Signs List

| | |
|---|---|
| 1 | Autonomous navigation system |
| 2 | State utilization system |
| 11 | Six-axis inertial sensor |
| 12 | GNSS receiver |
| 13 | Sensor attachment angle detection unit |
| 14 | Control unit |
| 15 | Sensor output conversion unit |
| 16 | Kalman filter |
| 111 | Acceleration sensor |
| 112 | Gyroscope |
| 161 | Prediction step execution unit |
| 162 | Filtering step execution unit. |

**Claims**

1.　An autonomous navigation system (1) mounted on a moving body, comprising:

an inertial sensor (11);
a yaw angle angle range detection means (13) configured to detect, as a yaw angle angle range, an angle range to which a yaw angle of an attachment angle of the inertial sensor with respect to the moving body belongs;
a conversion means (15) configured to convert and output an output of the inertial sensor; and
a Kalman filter (16) configured to estimate a state of the moving body using an output of the conversion means, wherein the state estimated by the Kalman filter includes an attachment angle of the inertial sensor, and
the conversion means is configured to convert the output of the inertial sensor into an output of a virtual inertial sensor in which a yaw angle of an attachment angle with respect to the moving body is within ±90° according to the yaw angle angle range detected by the yaw angle angle range detection means, and to output the converted output.

2.　The autonomous navigation system according to claim 1,

wherein the yaw angle angle range detection means is configured to detect, as the yaw angle angle range, an angle range to which the yaw angle of the attachment angle of the inertial sensor with respect to the moving body belongs, among an angle range between -45° and +45°, an angle range between +45° and +135°, an angle range between +135° and +180°, an angle range between -45° and -135°, and an angle range between -135° and -180°, and

the conversion means is configured to convert the output of the inertial sensor

into an output of a virtual inertial sensor in which a yaw angle of an attachment angle with respect to the moving body is at least within ±45° according to the yaw angle angle range detected by the yaw angle angle range detection means, and outputs the converted output.

3. The autonomous navigation system according to claim 2,

wherein the inertial sensor is an inertial sensor that is configured to output accelerations ax, ay, az in three orthogonal axial directions of X, Y, and Z, and
the conversion means is configured to perform conversion of the accelerations ax, ay, az into accelerations ax', ay', az' as the conversion, and to perform conversion into the accelerations ax', ay', az' by setting ax', ay', az' = ax, ay, az
when the yaw angle angle range detected by the yaw angle angle range detection means is an angle range between -45° and +45°,

$$ax', ay', az' = -ay, ax, az$$

when the yaw angle angle range detected by the yaw angle angle range detection means is an angle range between +45° and +135°,

$$ax', ay', az' = -ax, -ay, az$$

when the yaw angle angle range detected by the yaw angle angle range detection means is an angle range between +135° and +180°,

$$ax', ay', az' = ay, -ax, az$$

when the yaw angle angle range detected by the yaw angle angle range detection means is an angle range between -45° and -135°, and

$$ax', ay', az' = -ax, -ay, az$$

when the yaw angle angle range detected by the yaw angle angle range detection means is an angle range between -135° and -180°.

4. The autonomous navigation system according to claim 2 or 3,

wherein the inertial sensor is an inertial sensor that is configured to output angular velocities ωx, ωy, ωz around three orthogonal axes of X, Y, and Z, and
the conversion means is configured to perform conversion of the angular velocities ωx, ωy, ωz into angular velocities ωx', ωy', ωz' as the conversion, and to perform conversion into the angular velocities ωx', ωy', ωz' by setting ωx', ωy', ωz' = ωx, ωy, ωz
when the yaw angle angle range detected by the yaw angle angle range detection means is an angle range between -45° and +45°,

$$ωx', ωy', ωz' = -ωy, ωx, ωz$$

when the yaw angle angle range detected by the yaw angle angle range detection means is an angle range between +45° and +135°,

$$ωx', ωy', ωz' = -ωx, -ωy, ωz$$

when the yaw angle angle range detected by the yaw angle angle range detection means is an angle range between +135° and +180°,

$$\omega x', \omega y', \omega z' = \omega y, -\omega x, \omega z$$

when the yaw angle angle range detected by the yaw angle angle range detection means is an angle range between -45° and -135 °, and

$$\omega x', \omega y', \omega z' = -\omega x, -\omega y, \omega z$$

when the yaw angle angle range detected by the yaw angle angle range detection means is an angle range between -135° and -180°.

5. The autonomous navigation system according to claim 3 or 4,

wherein the inertial sensor is configured to output angular velocities $\omega x$, $\omega y$, $\omega z$ around the three axes of X, Y, and Z in addition to the accelerations $ax$, $ay$, $az$, and
the conversion means is configured to further perform conversion of the angular velocities $\omega x$, $\omega y$, $\omega z$ into angular velocities $\omega x'$, $\omega y'$, $\omega z'$ as the conversion, and to perform conversion into the angular velocities $\omega x'$, $\omega y'$, $\omega z'$ by setting $\omega x'$, $\omega y'$,

$$\omega z' = \omega x, \omega y, \omega z$$

when the yaw angle angle range detected by the yaw angle angle range detection means is an angle range between -45° and +45°,

$$\omega x', \omega y', \omega z' = -\omega y, \omega x, \omega z$$

when the yaw angle angle range detected by the yaw angle angle range detection means is an angle range between +45° and +135°,

$$\omega x', \omega y', \omega z' = -\omega x, -\omega y, \omega z$$

when the yaw angle angle range detected by the yaw angle angle range detection means is an angle range between +135° and +180°,

$$\omega x', \omega y', \omega z' = \omega y, -\omega x, \omega z$$

when the yaw angle angle range detected by the yaw angle angle range detection means is an angle range between -45° and -135 °, and

$$\omega x', \omega y', \omega z' = -\omega x, -\omega y, \omega z$$

when the yaw angle angle range detected by the yaw angle angle range detection means is an angle range between -135° and -180°.

6. The autonomous navigation system according to claim 1, 2, 3, 4, or 5,

wherein the yaw angle angle range detection means is configured to detect the yaw angle of the attachment angle of the inertial sensor with respect to the moving body, and
the autonomous navigation system includes
an initial value setting means configured to calculate a yaw angle of the virtual inertial sensor on the basis of the yaw angle and the yaw angle angle range detected by the yaw angle angle range detection means and to set the yaw angle in the Kalman filter as an initial value of a yaw angle of an attachment angle estimated by the Kalman filter.

7. The autonomous navigation system according to claim 6,

wherein the yaw angle angle range detection means is configured to detect a roll angle and a pitch angle of the attachment angle of the inertial sensor with respect to the moving body, and
the initial value setting means is configured to calculate a pitch angle of the virtual inertial sensor on the basis of the roll angle, the pitch angle, and the yaw angle angle range detected by the yaw angle angle range detection means, and to set the pitch angle in the Kalman filter as an initial value of a pitch angle of an attachment angle estimated by the Kalman filter.

8. The autonomous navigation system according to claim 2, 3, 4, or 5,

wherein the yaw angle angle range detection means is configured to detect a roll angle A1, a pitch angle A2, and a yaw angle A3 of the attachment angle of the inertial sensor with respect to the moving body, and
the autonomous navigation system includes
an initial value setting means configured to set an initial value SA2 of a pitch angle and an initial value SA3 of a yaw angle of an attachment angle estimated by the Kalman filter,
wherein the initial value setting means is configured to
calculate the initial value SA2 and the initial value SA3 of the yaw angle as

$$SA2 = A2$$

$$SA3 = A3$$

when the yaw angle angle range detected by the yaw angle angle range detection means is an angle range between -45° and +45°,

$$SA2 = A1$$

$$SA3 = A3\text{-}90°$$

when the yaw angle angle range detected by the yaw angle angle range detection means is an angle range between +45° and +135°,

$$SA2 = \text{-}A2$$

$$SA3 = A3\text{-}180°$$

when the yaw angle angle range detected by the yaw angle angle range detection means is an angle range between +135° and +180°,

$$SA2 = \text{-}A1$$

$$SA3 = A3\text{+}90°$$

when the yaw angle angle range detected by the yaw angle angle range detection means is an angle range between -45° and -135°, and

$$SA2 = \text{-}A2$$

$$SA3 = A3\text{+}180°$$

when the yaw angle angle range detected by the yaw angle angle range detection means is an angle range between -135° and -180°.

**Patentansprüche**

1. Autonomes Navigationssystem (1), das an einem beweglichen Körper montiert ist, aufweisend:

   einen Trägheitssensor (11);
   eine Gierwinkel-Winkelbereichsdetektionseinrichtung (13), die dazu ausgelegt ist, als Gierwinkel-Winkelbereich einen Winkelbereich zu detektieren, zu dem ein Gierwinkel eines Befestigungswinkels des Trägheitssensors in Bezug auf den beweglichen Körper gehört;
   eine Umwandlungseinrichtung (15), die dazu ausgelegt ist, eine Ausgabe des Trägheitssensors umzuwandeln und auszugeben; und
   ein Kalman-Filter (16), das dazu ausgelegt ist, einen Zustand des beweglichen Körpers unter Verwendung einer Ausgabe der Umwandlungseinrichtung zu schätzen,
   wobei der von dem Kalman-Filter geschätzte Zustand einen Befestigungswinkel des Trägheitssensors aufweist, und
   die Umwandlungseinrichtung dazu ausgelegt ist, die Ausgabe des Trägheitssensors in eine Ausgabe eines virtuellen Trägheitssensors umzuwandeln, bei dem ein Gierwinkel eines Befestigungswinkels in Bezug auf den sich bewegenden Körper innerhalb von $\pm 90°$ gemäß dem von der Gierwinkel-Winkelbereichsdetektionseinrichtung detektierten Gierwinkel-Winkelbereich liegt, und die umgewandelte Ausgabe auszugeben.

2. Autonomes Navigationssystem nach Anspruch 1,

   wobei die Gierwinkel-Winkelbereichsdetektionseinrichtung dazu ausgelegt ist, als Gierwinkel-Winkelbereich einen Winkelbereich, zu dem der Gierwinkel des Befestigungswinkels des Trägheitssensors in Bezug auf den sich bewegenden Körper gehört, von einem Winkelbereich zwischen -45° und +45°, einem Winkelbereich zwischen +45° und +135°, einem Winkelbereich zwischen +135° und +180°, einem Winkelbereich zwischen -45° und -135° und einem Winkelbereich zwischen -135° und 180° zu detektieren, und
   wobei die Umwandlungseinrichtung dazu ausgelegt ist, die Ausgabe des Trägheitssensors in eine Ausgabe eines virtuellen Trägheitssensors umzuwandeln, bei dem ein Gierwinkel eines Befestigungswinkels in Bezug auf den sich bewegenden Körper mindestens innerhalb von $\pm 45°$ gemäß dem von der Gierwinkel-Winkelbereichsdetektionseinrichtung detektierten Gierwinkel-Winkelbereich liegt, und die umgewandelte Ausgabe auszugeben.

3. Autonomes Navigationssystem nach Anspruch 2,

   wobei der Trägheitssensor ein Trägheitssensor ist, der dazu ausgelegt ist, Beschleunigungen ax, ay, az in drei orthogonalen Achsenrichtungen von X, Y und Z auszugeben, und
   wobei die Umwandlungseinrichtung dazu ausgelegt ist, die Umwandlung der Beschleunigungen ax, ay, az in Beschleunigungen ax', ay', az' als die Umwandlung durchzuführen und die Umwandlung in die Beschleunigungen ax', ay', az' durch das Vorgeben von ax', ay', az' = ax, ay, az durchzuführen,
   wenn der von der Gierwinkel-Winkelbereichsdetektionseinrichtung detektierte Gierwinkel-Winkelbereich ein Winkelbereich zwischen -45° und +45° ist,

$$ax', ay', az' = -ay, ax, az$$

   wenn der von der Gierwinkel-Winkelbereichsdetektionseinrichtung detektierte Gierwinkel-Winkelbereich ein Winkelbereich zwischen +45° und +135° ist,

$$ax', ay', az' = -ax, -ay, az$$

   wenn der von der Gierwinkel-Winkelbereichsdetektionseinrichtung detektierte Gierwinkel-Winkelbereich ein Winkelbereich zwischen +135° und +180° ist,

$$ax', ay', az' = ay, -ax, az$$

   wenn der von der Gierwinkel-Winkelbereichsdetektionseinrichtung detektierte Gierwinkel-Winkelbereich ein Winkelbereich zwischen -45° und -135° ist, und

$$ax', ay', az' = -ax, -ay, az$$

wenn der von der Gierwinkel-Winkelbereichsdetektionseinrichtung detektierte Gierwinkel-Winkelbereich ein Winkelbereich zwischen -135° und -180° ist.

4. Autonomes Navigationssystem nach Anspruch 2 oder 3,

wobei der Trägheitssensor ein Trägheitssensor ist, der dazu ausgelegt ist, Winkelgeschwindigkeiten $\omega x$, $\omega y$, $\omega z$ um drei orthogonale Achsen von X, Y und Z auszugeben, und
die Umwandlungseinrichtung dazu ausgelegt ist, die Umwandlung der Winkelgeschwindigkeiten $\omega x$, $\omega y$, $\omega z$ in Winkelgeschwindigkeiten $\omega x'$, $\omega y'$, $\omega z'$ als die Umwandlung durchzuführen und die Umwandlung in die Winkelgeschwindigkeiten $\omega x'$, $\omega y'$, $\omega z'$ durch Vorgeben von $\omega x'$, $\omega y'$, $\omega z' = \omega x$, $\omega y$, $\omega z$ durchzuführen,
wenn der von der Gierwinkel-Winkelbereichsdetektionseinrichtung detektierte Gierwinkel-Winkelbereich ein Winkelbereich zwischen -45° und +45° ist,

$$\omega x', \omega y', \omega z' = -\omega y, \omega x, \omega z$$

wenn der von der Gierwinkel-Winkelbereichsdetektionseinrichtung detektierte Gierwinkel-Winkelbereich ein Winkelbereich zwischen +45° und +135° ist,

$$\omega x', \omega y', \omega z' = -\omega x, -\omega y, \omega z$$

wenn der von der Gierwinkel-Winkelbereichsdetektionseinrichtung detektierte Gierwinkel-Winkelbereich ein Winkelbereich zwischen +135° und +180° ist,

$$\omega x', \omega y', \omega z' = \omega y, -\omega x, \omega z$$

wenn der von der Gierwinkel-Winkelbereichsdetektionseinrichtung detektierte Gierwinkel-Winkelbereich ein Winkelbereich zwischen -45° und -135° ist, und

$$\omega x', \omega y', \omega z' = -\omega x, -\omega y, \omega z$$

wenn der von der Gierwinkel-Winkelbereichsdetektionseinrichtung detektierte Gierwinkel-Winkelbereich ein Winkelbereich zwischen -135° und -180° ist.

5. Autonomes Navigationssystem nach Anspruch 3 oder 4,

wobei der Trägheitssensor dazu ausgelegt ist, zusätzlich zu den Beschleunigungen ax, ay, az Winkelgeschwindigkeiten $\omega x$, $\omega y$, $\omega z$ um die drei Achsen von X, Y und Z auszugeben, und
die Umwandlungseinrichtung dazu ausgelegt ist, ferner die Umwandlung der Winkelgeschwindigkeiten $\omega x$, $\omega y$, $\omega z$ in die Winkelgeschwindigkeiten $\omega x'$, $\omega y'$, $\omega z'$ als die Umwandlung durchzuführen und die Umwandlung in die Winkelgeschwindigkeiten $\omega x'$, $\omega y'$, $\omega z'$ durch Vorgeben von $\omega x'$, $\omega y'$, $\omega z' = \omega x$, $\omega y$, $\omega z$ durchzuführen,
wenn der von der Gierwinkel-Winkelbereichsdetektionseinrichtung detektierte Gierwinkel-Winkelbereich ein Winkelbereich zwischen -45° und +45° ist,
$\omega x'$, $\omega y'$, $\omega z' = -\omega y, \omega x, \omega z$
wenn der von der Gierwinkel-Winkelbereichsdetektionseinrichtung detektierte Gierwinkel-Winkelbereich ein Winkelbereich zwischen +45° und +135° ist,

$$\omega x', \omega y', \omega z' = -\omega x, -\omega y, \omega z$$

wenn der von der Gierwinkel-Winkelbereichsdetektionseinrichtung detektierte Gierwinkel-Winkelbereich ein Winkelbereich zwischen +135° und +180° ist,

$$\omega x', \omega y', \omega z' = \omega y, -\omega x, \omega z$$

wenn der von der Gierwinkel-Winkelbereichsdetektionseinrichtung detektierte Gierwinkel-Winkelbereich ein Winkelbereich zwischen -45° und -135° ist, und

$$\omega x', \omega y', \omega z' = -\omega x, -\omega y, \omega z$$

wenn der von der Gierwinkel-Winkelbereichsdetektionseinrichtung detektierte Gierwinkel-Winkelbereich ein Winkelbereich zwischen -135° und -180° ist.

6. Autonomes Navigationssystem nach Anspruch 1, 2, 3, 4 oder 5,

wobei die Gierwinkel-Winkelbereichsdetektionseinrichtung dazu ausgelegt ist, den Gierwinkel des Befestigungswinkels des Trägheitssensors in Bezug auf den sich bewegenden Körper zu detektieren, und
das autonome Navigationssystem aufweist:
eine Anfangswertvorgabeeinrichtung, die dazu ausgelegt ist, einen Gierwinkel des virtuellen Trägheitssensors auf Grundlage des Gierwinkels und des von der Gierwinkel-Winkelbereichsdetektionseinrichtung detektierten Gierwinkel-Winkelbereichs zu berechnen und den Gierwinkel in dem Kalman-Filter als Anfangswert eines Gierwinkels eines von dem Kalman-Filter geschätzten Befestigungswinkels vorzugeben.

7. Autonomes Navigationssystem nach Anspruch 6,

wobei die Gierwinkel-Winkelbereichsdetektionseinrichtung dazu ausgelegt ist, einen Rollwinkel und einen Neigungswinkel des Befestigungswinkels des Trägheitssensors in Bezug auf den sich bewegenden Körper zu detektieren, und
die Anfangswertvorgabeeinrichtung dazu ausgelegt ist, einen Neigungswinkel des virtuellen Trägheitssensors auf Grundlage des Rollwinkels, des Neigungswinkels und des von der Gierwinkel-Winkelbereichsdetektionseinrichtung detektierten Gierwinkel-Winkelbereichs zu berechnen und den Neigungswinkel in dem Kalman-Filter als Anfangswert eines Neigungswinkels eines von dem Kalman-Filter geschätzten Befestigungswinkels vorzugeben.

8. Autonomes Navigationssystem nach Anspruch 2, 3, 4 oder 5,

wobei die Gierwinkel-Winkelbereichsdetektionseinrichtung dazu ausgelegt ist, einen Rollwinkel A1, einen Neigungswinkel A2 und einen Gierwinkel A3 des Befestigungswinkels des Trägheitssensors in Bezug auf den sich bewegenden Körper zu detektieren, und
das autonome Navigationssystem aufweist:
eine Anfangswertvorgabeeinrichtung, die dazu ausgelegt ist, einen Anfangswert SA2 eines Neigungswinkels und einen Anfangswert SA3 eines Gierwinkels eines von dem Kalman-Filter geschätzten Befestigungswinkels vorzugeben,
wobei die Anfangswertvorgabeeinrichtung dazu ausgelegt ist,
den Anfangswert SA2 und den Anfangswert SA3 des Gierwinkels zu berechnen als:

$$SA2 = A2$$

$$SA3 = A3$$

wenn der von der Gierwinkel-Winkelbereichsdetektionseinrichtung detektierte Gierwinkel-Winkelbereich ein Winkelbereich zwischen -45° und +45° ist,

$$SA2 = A1$$

$$SA3 = A3\text{-}90°$$

wenn der von der Gierwinkel-Winkelbereichsdetektionseinrichtung detektierte Gierwinkel-Winkelbereich ein Winkelbereich zwischen +45° und +135° ist,

$$SA2 = -A2$$

$$SA3- = A3-180°$$

wenn der von der Gierwinkel-Winkelbereichsdetektionseinrichtung detektierte Gierwinkel-Winkelbereich ein Winkelbereich zwischen +135° und +180° ist,

$$SA2 = -A1$$

$$SA3 = A3+90°$$

wenn der von der Gierwinkel-Winkelbereichsdetektionseinrichtung detektierte Gierwinkel-Winkelbereich ein Winkelbereich zwischen -45° und -135° ist, und

$$SA2 = -A2$$

$$SA3 = A3+180°$$

wenn der von der Gierwinkel-Winkelbereichsdetektionseinrichtung detektierte Gierwinkel-Winkelbereich ein Winkelbereich zwischen -135° und -180° ist.

## Revendications

1. Un système de navigation autonome (1) monté sur un corps en mouvement, comprenant :

   un capteur inertiel (11) ;
   un moyen de détection de la plage d'angle de lacet (13) configuré pour détecter, comme plage d'angle de lacet, une plage d'angle à laquelle appartient un angle de lacet d'un angle de fixation du capteur inertiel par rapport au corps en mouvement ;
   un moyen de conversion (15) configuré pour convertir et sortir une sortie du capteur inertiel ; et
   un filtre de Kalman (16) configuré pour estimer un état du corps en mouvement en utilisant une sortie du moyen de conversion,
   dans lequel l'état estimé par le filtre de Kalman comprend un angle de fixation du capteur inertiel, et
   le moyen de conversion est configuré pour convertir la sortie du capteur inertiel en une sortie d'un capteur inertiel virtuel dans lequel un angle de lacet d'un angle de fixation par rapport au corps en mouvement est dans les +90° selon la plage d'angle de lacet détectée par le moyen de détection de la plage d'angle de lacet, et pour sortir la sortie convertie.

2. Le système de navigation autonome selon la revendication 1,

   dans lequel le moyen de détection de la plage d'angle de lacet est configuré pour détecter, comme plage d'angle de lacet, une plage d'angle à laquelle appartient l'angle de lacet de l'angle de fixation du capteur inertiel par rapport au corps en mouvement, parmi une plage d'angle entre -45° et +45°, une plage d'angle entre +45° et +135°, une plage d'angle entre +135° et +180°, une plage d'angle entre -45° et -135°, et une plage d'angle entre -135° et -180°, et
   le moyen de conversion est configuré pour convertir la sortie du capteur inertiel en une sortie d'un capteur inertiel virtuel dans lequel un angle de lacet d'un angle de fixation par rapport au corps en mouvement est au moins dans les +45° selon la plage d'angle de lacet détectée par le moyen de détection de la plage d'angle de lacet, et sort la sortie convertie.

3. Le système de navigation autonome selon la revendication 2,

   dans lequel le capteur inertiel est un capteur inertiel configuré pour sortir des accélérations ax, ay, az dans trois directions axiales orthogonales de X, Y, et Z, et
   le moyen de conversion est configuré pour effectuer la conversion des accélérations ax, ay, az en accélérations ax', ay', az' comme conversion, et pour effectuer la conversion en accélérations ax', ay', az' en réglant ax', ay', az' = ax, ay, az

lorsque la plage d'angle de lacet détectée par le moyen de détection de la plage d'angle de lacet est une plage d'angle entre -45° et +45°,

$$ax', ay', az' = - ay, ax, az$$

lorsque la plage d'angle de lacet détectée par le moyen de détection de la plage d'angle de lacet est une plage d'angle entre +45° et +135°,

$$ax', ay', az' = - ax, -ay, az$$

lorsque la plage d'angle de lacet détectée par le moyen de détection de la plage d'angle de lacet est une plage d'angle entre +135° et +180°,

$$ax', ay', az' = ay, -ax, az$$

lorsque la plage d'angle de lacet détectée par le moyen de détection de la plage d'angle de lacet est une plage d'angle entre -45° et -135°, et

$$ax', ay', az' = - ax, -ay, az$$

lorsque la plage d'angle de lacet détectée par le moyen de détection de la plage d'angle de lacet est une plage d'angle entre -135° et -180°.

4. Le système de navigation autonome selon la revendication 2 ou 3,

dans lequel le capteur inertiel est un capteur inertiel configuré pour sortir des vitesses angulaires wx, ωy, ωz autour de trois axes orthogonaux de X, Y, et Z, et
le moyen de conversion est configuré pour effectuer la conversion des vitesses angulaires ωx, ωy, ωz en vitesses angulaires ωx', wy', ωz' comme conversion, et pour effectuer la conversion en vitesses angulaires wx', wy', wz' en réglant wx', ωy', ωz' = ωx, ωy, ωz
lorsque la plage d'angle de lacet détectée par le moyen de détection de la plage d'angle de lacet est une plage d'angle entre -45° et +45°,

$$ωx', ωy', ωz' = -ωy, ωx, ωz$$

lorsque la plage d'angle de lacet détectée par le moyen de détection de la plage d'angle de lacet est une plage d'angle entre +45° et +135°,

$$ωx', ωy', ωz' = -ωx, -ωy, ωz$$

lorsque la plage d'angle de lacet détectée par le moyen de détection de la plage d'angle de lacet est une plage d'angle entre +135° et +180°,

$$ωx', ωy', ωz' = ωy, -ωx, ωz$$

lorsque la plage d'angle de lacet détectée par le moyen de détection de la plage d'angle de lacet est une plage d'angle entre -45° et -135°, et

$$ωx', ωy', ωz' = - ωx, -ωy, ωz$$

lorsque la plage d'angle de lacet détectée par le moyen de détection de la plage d'angle de lacet est une plage d'angle entre -135° et -180°.

5. Le système de navigation autonome selon la revendication 3 ou 4,

dans lequel le capteur inertiel est configuré pour sortir des vitesses angulaires ωx, ωy, ωz autour des trois axes de X, Y, et Z en plus des accélérations ax, ay, az, et

le moyen de conversion est configuré pour effectuer en outre la conversion des vitesses angulaires ωx, ωy, ωz en vitesses angulaires wx', ωy', wz' comme conversion, et pour effectuer la conversion en vitesses angulaires ωx', ωy', ωz' en réglant wx', ωy', ωz' = wx, ωy, ωz

lorsque la plage d'angle de lacet détectée par le moyen de détection de la plage d'angle de lacet est une plage d'angle entre -45° et +45°,

$$\omega x', \ \omega y', \ \omega z' = -\omega y, \ \omega x, \ \omega z$$

lorsque la plage d'angle de lacet détectée par le moyen de détection de la plage d'angle de lacet est une plage d'angle entre +45° et +135°,

$$\omega x', \ \omega y', \ \omega z' = -\omega x, \ -\omega y, \ \omega z$$

lorsque la plage d'angle de lacet détectée par le moyen de détection de la plage d'angle de lacet est une plage d'angle entre +135° et +180°,

$$\omega x', \ \omega y', \ \omega z' = \omega y, \ -\omega x, \ \omega z$$

lorsque la plage d'angle de lacet détectée par le moyen de détection de la plage d'angle de lacet est une plage d'angle entre -45° et -135°, et

$$\omega x', \ \omega y', \ \omega z' = -\omega x, \ -\omega y, \ \omega z$$

lorsque la plage d'angle de lacet détectée par le moyen de détection de la plage d'angle de lacet est une plage d'angle entre -135° et -180°.

6. Le système de navigation autonome selon la revendication 1, 2, 3, 4, ou 5,

dans lequel le moyen de détection de la plage d'angle de lacet est configuré pour détecter l'angle de lacet de l'angle de fixation du capteur inertiel par rapport au corps en mouvement, et
le système de navigation autonome comprend
un moyen de réglage de la valeur initiale configuré pour calculer un angle de lacet du capteur inertiel virtuel sur la base de l'angle de lacet et de la plage d'angle de lacet détectée par le moyen de détection de la plage d'angle de lacet et pour régler l'angle de lacet dans le filtre de Kalman comme valeur initiale d'un angle de lacet d'un angle de fixation estimé par le filtre de Kalman.

7. Le système de navigation autonome selon la revendication 6,
dans lequel le moyen de détection de la plage d'angle de lacet est configuré pour détecter un angle de roulis et un angle de tangage de l'angle de fixation du capteur inertiel par rapport au corps en mouvement, et
le moyen de réglage de la valeur initiale est configuré pour calculer un angle de tangage du capteur inertiel virtuel sur la base de l'angle de roulis, de l'angle de tangage, et de la plage d'angle de lacet détectée par le moyen de détection de la plage d'angle de lacet, et pour régler l'angle de tangage dans le filtre de Kalman comme valeur initiale d'un angle de tangage d'un angle de fixation estimé par le filtre de Kalman.

8. Le système de navigation autonome selon la revendication 2, 3, 4, ou 5,

dans lequel le moyen de détection de la plage d'angle de lacet est configuré pour détecter un angle de roulis A1, un angle de tangage A2, et un angle de lacet A3 de l'angle de fixation du capteur inertiel par rapport au corps en mouvement, et
le système de navigation autonome comprend
un moyen de réglage de la valeur initiale configuré pour régler une valeur initiale SA2 d'un angle de tangage et une valeur initiale SA3 d'un angle de lacet d'un angle de fixation estimé par le filtre de Kalman,
dans lequel le moyen de réglage de la valeur initiale est configuré pour
calculer la valeur initiale SA2 et la valeur initiale SA3 de l'angle de lacet comme

$$SA2 = A2$$

$$SA3 = A3$$

lorsque la plage d'angle de lacet détectée par le moyen de détection de la plage d'angle de lacet est une plage d'angle entre -45° et +45°,

$$SA2 = A1$$

$$SA3 = A3\text{-}90°$$

lorsque la plage d'angle de lacet détectée par le moyen de détection de la plage d'angle de lacet est une plage d'angle entre +45° et +135°,

$$SA2 = \text{-}A2$$

$$SA3 = A3\text{-}180°$$

lorsque la plage d'angle de lacet détectée par le moyen de détection de la plage d'angle de lacet est une plage d'angle entre +135° et +180°,

$$SA2 = \text{-}A1$$

$$SA3 = A3\text{+}90°$$

lorsque la plage d'angle de lacet détectée par le moyen de détection de la plage d'angle de lacet est une plage d'angle entre -45° et -135°, et

$$SA2 = \text{-}A2$$

$$SA3 = A3\text{+}180°$$

lorsque la plage d'angle de lacet détectée par le moyen de détection de la plage d'angle de lacet est une plage d'angle entre -135° et -180°.

# FIG. 1

AUTONOMOUS NAVIGATION SYSTEM

STATE UTILIZATION SYSTEM — 2

SENSOR ATTACHMENT ANGLE DETECTION UNIT — 13

CONTROL UNIT — 14

SENSOR OUTPUT CONVERSION UNIT — 15

KALMAN FILTER — 16

PREDICTION STEP EXECUTION UNIT — 161

FILTERING STEP EXECUTION UNIT — 162

ACCELERATION SENSOR (3 AXES) — 111

GYROSCOPE (3 AXES) — 112

SIX-AXIS INERTIAL SENSOR — 11

GNSS RECEIVER — 12

A1, A2, A3

A2, A3'

$T_a()$, $T_\omega()$

$a_x, a_y, a_z$

$\omega_x, \omega_y, \omega_z$

$a_x', a_y', a_z'$

$\omega_x', \omega_y', \omega_z'$

1

# FIG. 2A

A3＝+120°

# FIG. 2B

A3＝−30°

FIG. 3A

FIG. 3B

FIG. 3C

FIG. 3D

FIG. 3E

ROTATION DIRECTION (+): CLOCKWISE

**REFERENCES CITED IN THE DESCRIPTION**

**Patent documents cited in the description**

- JP 5164645 B
- JP 2004239613 A
- US 2013338915 A1
- US 2010030471 A1